# EUROPEAN PATENT APPLICATION

(11) **EP 2 760 010 A1**
(43) Date of publication of application: **30.07.2014**
(21) Application number: 14150583.4
(22) Date of filing: 09.01.2014
(51) Int. Cl.: G09G 3/20, G09G 3/36

(54) **Array substrate and driving method thereof and display device**

(30) Priority: 25.01.2013 CN 201310030136
(71) Applicant: Beijing Boe Optoelectronics Technology Co. Ltd., Beijing 100176 (CN); Boe Technology Group Co. Ltd., Beijing 100015 (CN)
(72) Inventor: Li, Yue, 100176 Beijing (CN); Xue, Yanna, 100176 Beijing (CN); Wang, Lei, 100176 Beijing (CN)
(74) Representative: Michalski Hüttermann & Partner Patentanwälte

(57) **Abstract**

Embodiments of the present invention provide an array substrate and a driving method thereof and a display device. The array substrate includes multiple pixel groups arranged in a matrix form, multiple rows of gate lines arranged transversely which are corresponding to the pixel groups, and multiple columns of first and second data lines arranged longitudinally, wherein each pixel group includes a first pixel unit and a second pixel unit which are located in two adjacent rows; the gate line is connected to the first and second pixel unit in the corresponding pixel group respectively, the first and second data lines are respectively connected with the first and second pixel units in the corresponding pixel group to provide data signals to the first and second pixel units; wherein, the gate lines on the periphery of the pixel units are formed by metal of the same layer.

## Description

### Field of the Invention

The present invention relates to the field of display technology, in particular to an array substrate and a driving method thereof and a display device.

### Background of the Invention

At present, a display device with narrow frame has gradually become the mainstream development of display products, and the key to obtain a display device with a narrower frame is to reduce an area occupied by a gate line or data line circuit around a display area in an array substrate.

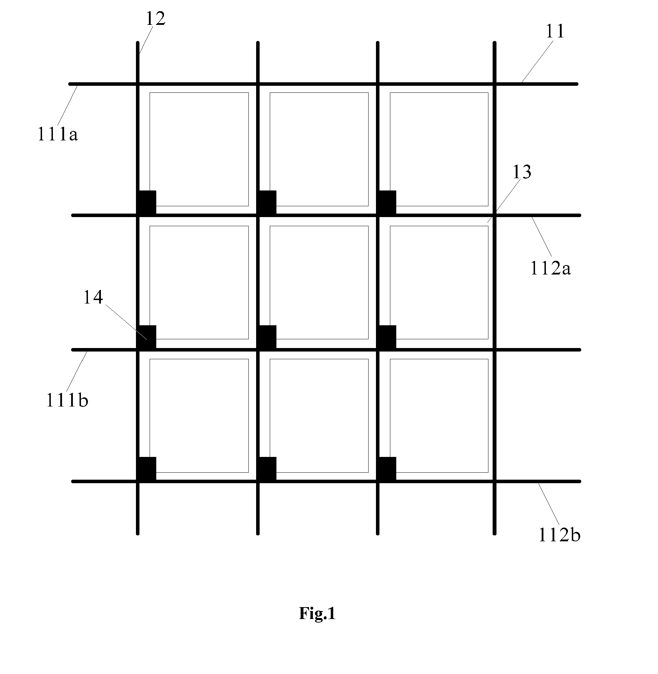

An existing array substrate may be as shown in Fig. 1, including multiple pixel units 13 segmented by gate lines 11 and data lines 12 crossed transversely and longitudinally, wherein the inside of each pixel unit 13 has a TFT (Thin Film Transistor) area 14, and the gate lines 11 and the data lines 12 drive the pixel units 13 to work through the TFTs in the TFT areas 14. In the existing array substrate, all the gate lines within the area of the pixel units 13 may be formed by metal of the same layer, whereas on the periphery of the pixel units 13, due to the limitation of the width of a packaged area, in order to further reduce the resistance of the gate lines 11, the gate lines on the periphery of the pixel units 13 are generally formed by metal of different layers. For example, in an actual display device product, gate driving signals input through gate lines in odd rows may enter the pixel area from the left side, and gate driving signals input through gate lines in even rows may enter the pixel area from the right side, wherein, peripheral leads 111a and 111b of gate lines in two adjacent odd rows are formed by metal of different layers, and peripheral leads 112a and 112b of gate lines in two adjacent even rows are formed by metal of different layers likewise. The array substrate with such structure has following shortcomings: lines on the periphery of the pixel units 13 are generally long, large resistance difference is produced between metal of different layers, and particularly for the thin gate lines, the resistance difference between gate lines in two adjacent rows is overally high, which readily results in a difference of displaying between the rows in the displaying process of the display device and causes H-line badness. Such shortcomings have adverse influence on the yield of the product.

### Summary of the Invention

Embodiments of the present invention provide an array substrate and a driving method thereof and a display device, which may avoid H-line badness and improve the yield of the display device product.

To fulfill the above-mentioned objective, the embodiments of the present invention adopt the following technical solutions:
one aspect of the embodiments of the present invention provides an array substrate, characterized by including: multiple pixel groups arranged in a matrix form, multiple rows of gate lines arranged transversely which are corresponding to the pixel groups, and multiple columns of first data lines and multiple columns of second data lines arranged longitudinally,
wherein each pixel group includes a first pixel unit and a second pixel unit, which are located in two adjacent rows;
the gate line is connected to the first pixel unit and the second pixel unit in the corresponding pixel group respectively, the first data line is connected with the first pixel unit in the corresponding pixel group to provide data signals to the first pixel unit, and the second data line is connected with the second pixel unit in the corresponding pixel group to provide data signals to the second pixel unit; and
wherein, the gate lines on the periphery of the pixel units are formed by metal of the same layer.

Another aspect of the embodiments of the present invention provides a display device, including the above-mentioned array substrate.

A further aspect of the embodiments of the present invention provides a method for driving the array substrate of claim 1, characterized by including steps executed in the following sequence:
inputting a row driving signal to the gate line in a current row, and controlling the first pixel unit and the second pixel unit in the pixel group corresponding to the gate line to be turned on;
inputting a first control signal through a first data line to charge the first pixel unit corresponding to this row of gate line;
inputting a second control signal through a second data line to charge the second pixel unit corresponding to this row of gate line;
stop inputting the row driving signal to the gate line in the current row, and inputting the row driving signal to gate line in the next row.

In the array substrate and the driving method thereof and the display device provided in the embodiments of the present invention, one gate line controls the first pixel unit and the second pixel unit in two adjacent rows which are adjacent to the gate line, the first pixel unit is charged by using the first data line, the second pixel unit is charged by using the second data line, and signals are sequentially output to the first pixel unit and the second pixel unit through the first data line and the second data line to realize progressive scanning of the array substrate, wherein, the two adjacent gate lines on the periphery of the pixel units are formed by metal of the same layer. In this way, the quantity of wiring of the gate lines may be effectively reduced, and the wiring of the gate lines with single-layer metal is realized; and since the gate lines may be formed by adopting the same mask process, the resistance difference between the gate lines in two adjacent rows is reduced, H-line badness of the display device is avoided, and the yield of the display device product is improved.

### Brief Description of the Drawings

To illustrate technical solutions in the embodiments of the present invention or in the prior art more clearly, a brief introduction to the accompanying drawings which are needed in the description of the embodiments or the prior art is given below. Apparently, the accompanying drawings described below are merely some of the embodiments of the present invention, based on which other drawings may be obtained by those of ordinary skill in the art without any creative effort.
Fig. 1 is a schematic diagram of a structure of an array substrate in the prior art;
Fig. 2 is a schematic diagram of a structure of an array substrate provided in an embodiment of the present invention;
Fig. 3 is a schematic diagram of a structure of another array substrate provided in an embodiment of the present invention;
Fig. 4 is a schematic diagram of a structure of a multistage output unit in the array substrate provided in an embodiment of the present invention;
Fig. 5 is a schematic diagram of circuit connection of the multistage output unit in the array substrate provided in an embodiment of the present invention;
Fig. 6 is a schematic waveform diagram of control signals for driving the array substrate provided in an embodiment of the present invention;
Fig. 7 is a schematic flow diagram of a method for driving an array substrate provided in an embodiment of the present invention.

### Detailed Description of the Embodiments

A clear and complete description of technical solutions in the embodiments of the present invention will be given below, in combination with the accompanying drawings in the embodiments of the present invention. Apparently, the embodiments described herein are merely a part, but not all, of the embodiments of the present invention. All of other embodiments, obtained by those of ordinary skill in the art based on the embodiments in the present invention, fall into the protection scope of the present invention.

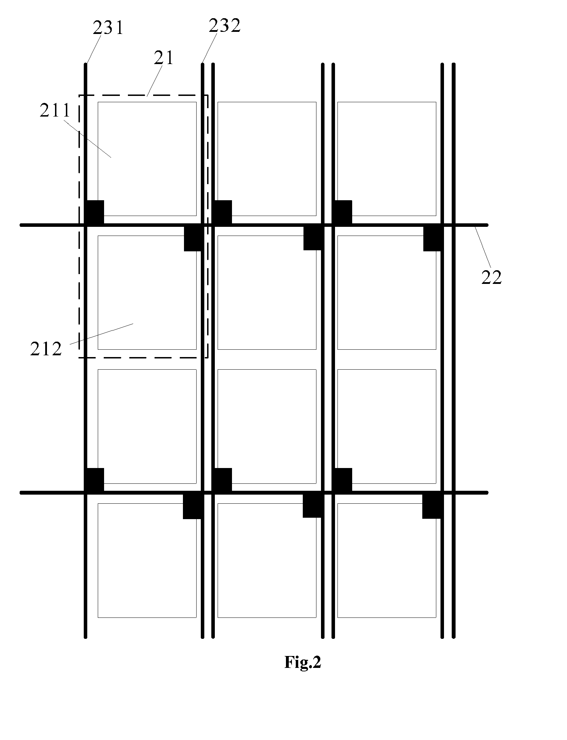

An array substrate provided in an embodiment of the present invention, as shown in Fig. 2, includes: multiple pixel groups 21 arranged in a matrix form, multiple rows of gate lines 22 corresponding to the respective pixel groups 21 and arranged transversely, and multiple columns of first data lines 231 and multiple columns of second data lines 232 arranged longitudinally.

Each pixel group 21 includes a first pixel unit 211 and a second pixel unit 212, which are located in two adjacent rows.

The gate line 22 is connected to the first pixel unit 211 and the second pixel unit 212 in the corresponding pixel group 21 respectively, the first data line 231 is connected with the first pixel unit 211 in the corresponding pixel group 21 to provide data signals to the first pixel unit 211, and the second data line 232 is connected with the second pixel unit 212 in the corresponding pixel group 21 to provide data signals to the second pixel unit 212;
wherein, the gate lines 22 on the periphery of the pixel units are formed by metal of the same layer.

In the array substrate provided in the embodiment of the present invention, one gate line controls the first pixel unit and the second pixel unit in the two adjacent rows adjacent to the gate line, the first pixel unit is charged using the first data line , the second pixel unit is charged using the second data line , and signals are sequentially output to the first pixel unit and the second pixel unit through the first data line and the second data line so as to realize progressive scanning of the array substrate, wherein, the two adjacent gate lines on the periphery of the pixel units are formed by metal of the same layer. In this way, the quantity of wiring of the gate lines may be effectively reduced, and the wiring of the gate lines with single-layer metal is realized; and since the gate lines may be formed by adopting the same mask process, the resistance difference between gate lines in two adjacent rows is reduced, H-line badness of the display device is avoided, and the yield of the display device product is improved.

It should be noted that, the first data lines 231 and the second data lines 232 may be arranged in parallel at any positions in pixel area. In a liquid crystal display panel shown in Fig. 2, the first data lines 231 and the second data lines 232 are located on two sides of the pixel groups 21 respectively. In this way, the second data line 232 in the current pixel group 21 is closely adjacent to the first data line 231 of the adjacent pixel group, so that there is no need to add a black matrix structure additionally to shield the second data line 232, and the aperture ratio of the liquid crystal display panel is ensured.

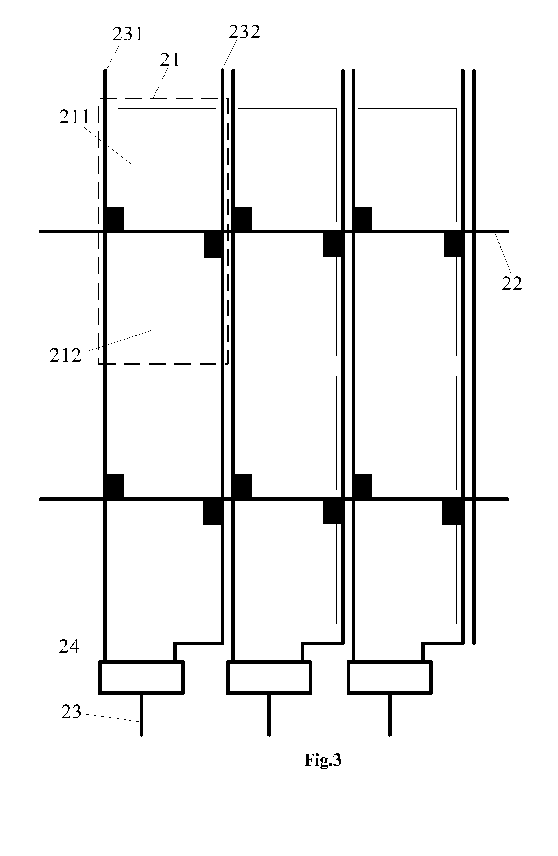

Further, when two rows of pixels are controlled by one row of gate line, a problem occurs, namely, when the gate line is at a high level, the two rows of pixels are in an on state. If the pixels are simultaneously charged by using different data lines in this period of time, the data lines need to be doubled due to differences in data signals, in this way, the cost of a data line driving circuit (such as a data line driving integrated circuit (IC)) is raised. Whereas if the pixels are charged by using the same quantity of data lines respectively in different periods of time, a problem that the first row of pixel leak electricity when the charging of the first row of pixel is completed and the second row of pixel is being charged is caused. This problem is solved by arranging multistage output units and particularly by adding a keeping capacitance in the present invention. As shown in Fig. 3, the array substrate may also include at least one multistage output unit 24.

The multistage output unit 24 may decompose signals output by a driving circuit of a data line 23 into data signals output respectively by the first data line 231 and the second data line 232.

Through the design of adding the multistage output unit 24 on the array substrate, the data signals may be output to the first data line and the second data line respectively with one data line, which realizes double-source output of one data line. Accordingly, the quantity of the data lines required to be driven by the data line driving circuit may be not increased under the condition that the quantity of the gate lines on the array substrate is halved, and a mode of implementing simultaneous input by using double quantity of data lines is avoided. The present invention effectively reduces the quantity of wiring of the data lines on the array substrate, and further reduces the production cost of the display device.

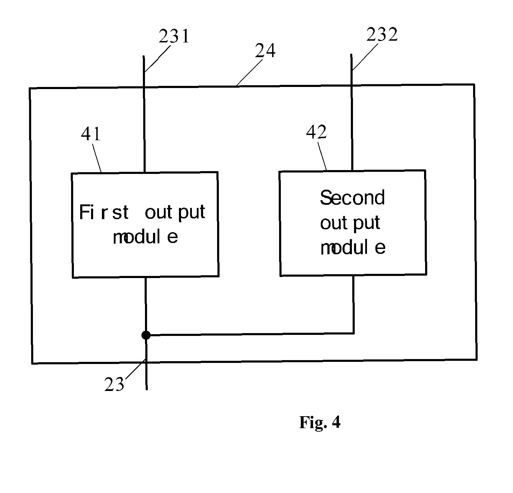

Specifically, as shown in Fig. 4, the multistage output unit 24 may include:
a first output module 41, for converting signals output by the driving circuit of the data line 23 into first data signals output by the first data line 231;
a second output module 42, for converting signals output by the driving circuit of the data line 23 into second data signals output by the second data line 232.

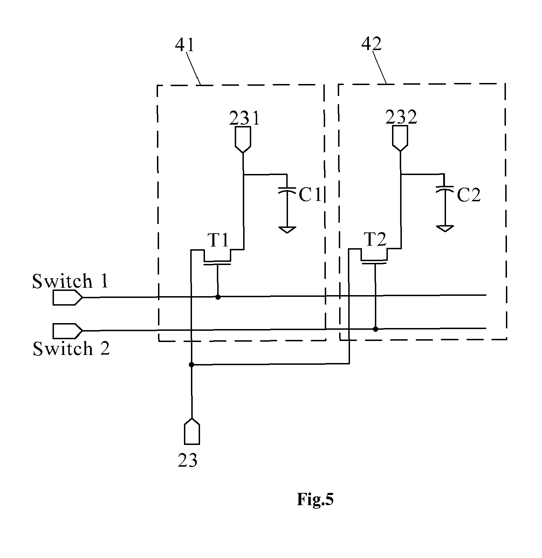

Further, as shown in Fig. 5, the first output module 41 may include:
a first transistor T1, of which a source is connected with the first data line 231, a grid is connected with a first switch signal Switch 1 and a drain is connected with the data line 23;
a first capacitor C1, of which one end is connected with the first data line 231 and the other end is grounded.

The second output module 42 may include:
a second transistor T2, of which a source is connected with the second data line 232, a grid is connected with a second switch signal Switch 2 and a drain is connected with the data line 23;
a second capacitor C2, of which one end is connected with the second data line 232 and the other end is grounded.
wherein, when the first switch signal Switch 1 controls the first transistor T1 to be turned on, the second switch signal Switch 2 controls the second transistor T2 to be turned off; and when the second switch signal Switch 2 controls the second transistor T2 to be turned on, the first switch signal Switch 1 controls the first transistor T1 to be turned off.

By adopting the multistage output unit with such structure, a column of data signals may be changed into two columns of data signals which are output respectively under the control of the switch signals, wherein, while the gate line controls the pixel units in the two adjacent rows adjacent to the gate line to be on-state all the time in the respective output processes of the first data line and the second data line, pixel units in one of the two adjacent rows may not be affected by continuous on-state of the gate line when pixel units in the other row are being scanned by adding capacitors for keeping voltage to the output ends of the first data line and the second data line, so that the quality of the display device product is improved.

It should be noted that, the transistors adopted in the embodiments of the present invention may be thin film transistors or field effect transistors or other devices with the same properties; and the source and the drain of the transistor adopted herein are symmetrical, so the source and the drain of the transistor do not have differences. In the embodiments of the present invention, in order to distinguish the two other ends of the transistor except for the gate, one end is called the source, and the other end is called the drain. Moreover, the transistors may be classified into N-type transistors and P-type transistors according to the properties of the transistors, and the N-type transistor is taken as an example for illustration in the embodiments of the present invention. It is easy for those skilled in the art to think of the idea of adopting the P-type transistors to implement the embodiments of the present invention without creative effort, so such idea falls within the protection scope of the embodiments of the present invention.

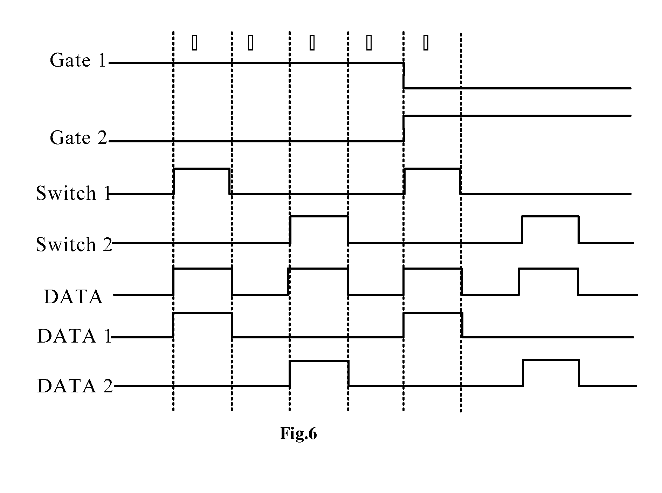

Specifically, the above-mentioned array substrate may be driven by adopting control signals shown in Fig. 6. Wherein, Gate 1 and Gate 2 indicate signals output by a first row of gate line and a second row of gate line respectively, Switch 1 and Switch 2 indicate the first switch signal and the second switch signal respectively, DATA indicates a signal input by the data line, DATA 1 indicates a first control signal output by the first data line, and DATA 2 indicates a second control signal output by the second data line. A method for driving the array substrate provided in the embodiment of the present invention is illustrated in detail below.

In the first stage, Gate 1 is high-level, so that the first row of pixel unit and the second row of pixel unit are turned on; meanwhile, Switch 1 is high-level, and Switch 2 is low-level, so DATA 1 outputs a data signal, and the first row of pixel unit is charged.

In the second stage, Gate 1 keeps high-level, and both Switch 1 and Switch 2 are low-level. Since the first capacitor Cl stores a voltage which is the same as the level of the data signal output in the first stage, the influence of continuous on-state of Gate 1 on the output of DATA 1 may be avoided, so that the scanning of the first row of pixel unit is completed.

In the third stage, Gate 1 keeps high-level, in the meanwhile, Switch 1 is low-level, and Switch 2 is high-level, so DATA 2 outputs a data signal, and the second row of pixel unit is charged.

In the fourth stage, Gate 1 keeps high-level, and both Switch 1 and Switch 2 are low-level. Since the second capacitor C2 stores a voltage which is the same as the level of the data signal output in the third stage, the influence of continuous on-state of Gate 1 on the output of DATA 2 may be avoided, so that the scanning of the second row of pixel unit is completed.

In the fifth stage, Gate 1 is low-level, Gate 2 is high-level, in the meanwhile, Switch 1 is high-level, and Switch 2 is low-level, so DATA 1 outputs a data signal, and the third row of pixel is charged.

And in a similar fashion, progressive scanning of the array substrate may be realized by repeating the above-mentioned processes.

In the array substrate provided in the embodiment of the present invention, one gate line controls the first pixel unit and the second pixel unit in the two adjacent rows adjacent to the gate line, the first pixel unit is charged by using the first data line, the second pixel unit is charged by using the second data line, and signals are sequentially output to the first pixel unit and the second pixel unit through the first data line and the second data line to realize progressive scanning of the array substrate, wherein, the two adjacent gate lines on the periphery of the pixel units are formed by metal of the same layer. In this way, the quantity of wiring of the gate lines may be effectively reduced, and the wiring of the gate lines with single-layer metal is realized; and since the gate lines may be formed by adopting the same mask process, the resistance difference between gate lines in two adjacent rows is reduced, H-line badness of the display device is avoided, and the yield of the display device product is improved.

The embodiment of the present invention provides a display device, which includes any above-mentioned array substrate. The display device may be any product or component with a display function, such as a liquid crystal display, a liquid crystal television, a digital photo frame, a mobile phone, a tablet computer or the like.

Wherein, the structure of the array substrate has been described in detail in the above-mentioned embodiments, and will not be repeated redundantly herein.

The display device provided in the embodiment of the present invention includes a array substrate, using one gate line to control a first pixel unit and a second pixel unit in the two adjacent rows adjacent to the gate line, the first pixel unit being charged by using the first data line, the second pixel unit being charged by using the second data line, and signals being sequentially output to the first pixel unit and the second pixel unit through the first data line and the second data line to realize progressive scanning of the array substrate, wherein, two adjacent gate lines on the periphery of the pixel units are formed by metal of the same layer. In this way, the quantity of wiring of the gate lines may be effectively reduced, and the wiring of the gate lines with single-layer metal is realized; and since the gate lines may be formed by adopting the same mask process, the resistance difference between gate lines in two adjacent rows is reduced, H-line badness of the display device is avoided, and the yield of the display device product is improved.

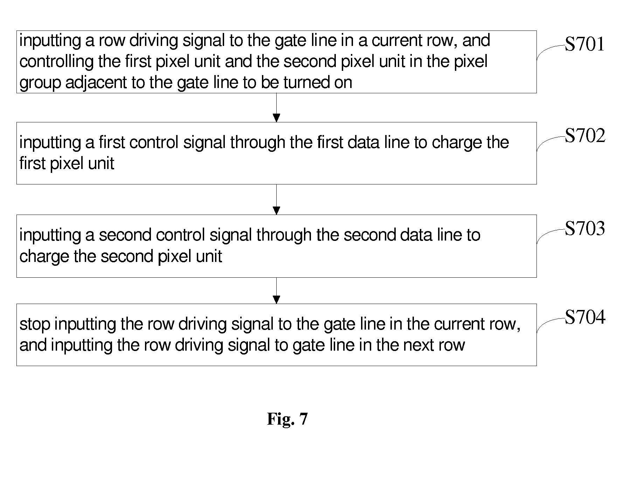

The embodiment of the present invention also provides a method for driving an array substrate, as shown in Fig. 7, including:
S701, inputting a row driving signal to a gate line in a current row, and controlling a first pixel unit and a second pixel unit in a pixel group corresponding to the gate line to be turned on;
S702, inputting a first control signal through a first data line to charge the first pixel unit corresponding to this row of gate line;
S703, inputting a second control signal through a second data line to charge the second pixel unit corresponding to this row of gate line;
S704, stop inputting the row driving signal to the gate line in the current row, and inputting the row driving signal to a gate line in the next row,
wherein, two adjacent gate lines on the periphery of the pixel units are formed by metal of the same layer.

In the array substrate provided in the embodiment of the present invention, one gate line controls the first pixel unit and the second pixel unit in the two adjacent rows adjacent to the gate line, the first pixel unit is charged by using the first data line, the second pixel unit is charged by using the second data line, and signals are sequentially output to the first pixel unit and the second pixel unit through the first data line and the second data line to realize progressive scanning of the array substrate, wherein, two adjacent gate lines on the periphery of the pixel units are formed by metal of the same layer. In this way, the quantity of wiring of the gate lines may be effectively reduced, and the wiring of the gate lines with single-layer metal is realized; and since the gate lines may be formed by adopting the same mask process, the resistance difference between gate lines in two adjacent rows is reduced, H-line badness of the display device is avoided, and the yield of the display device product is improved.

The method for driving an array substrate provided in the embodiment of the present invention may be used for driving the array substrate shown in Fig. 2. Further, the array substrate shown in Fig. 3 may include at least one multistage output unit. Correspondingly, as shown in Fig. 7, the method for driving an array substrate provided in the embodiment of the present invention may also include:
obtaining control signals respectively output by the first data line and the second data line from a signal output by the data line through a multistage output unit.

Through the design of adding the multistage output unit on the array substrate, data signals may be respectively output to the first data line and the second data line by using one data line, so that double-source output of one data line is realized. Accordingly, compared with a mode of implementing simultaneous input by using double quantity of data lines, the present invention effectively reduces the quantity of wiring of the data lines on the array substrate, and further reduces the production cost of the display device.

Specifically, the step of obtaining the control signals respectively output by the first data line and the second data line from a signal output by the data line through a multistage output unit may include:
obtaining a first control signal output by the first data line from the signal output by the data line through the first output module;
for example, the first switch signal may control the first transistor to be turned on, and the second switch signal controls the second transistor to be turned off, so the first control signal is output to the first data line through the first transistor by the data line;
obtaining a second control signal output by the second data line from the signal output by the data line through the second output module;
for example, the first switch signal controls the first transistor to be turned off, and the second switch signal controls the second transistor to be turned on, so the second control signal is output to the second data line through the second transistor by the data line.

It should be noted that, the method for driving an array substrate provided in the embodiment of the present invention may be used for driving the array substrate shown in Fig. 3. Wherein, the structure of the first output module may be as shown in Fig. 5, including a first transistor and a first capacitor. The second output module may also be as shown in Fig. 5, including a second transistor and a second capacitor.

By adopting the multistage output unit with such structure, a column of data signals may be changed into two columns of data signals which are output respectively under the control of the switch signals, wherein, while the gate line controls pixel units in the two adjacent rows adjacent to the gate line to be on-state all the time in the respective output processes of the first data line and the second data line, the pixel unit in one of the two adjacent rows may not be affected by continuous on-state of the gate line when pixel unit in the other row is being scanned by adding capacitors for keeping voltage at the output ends of the first data line and the second data line, so that the quality of the display device product is improved.

The foregoing descriptions are merely specific embodiments of the present invention, rather than limiting the protection scope of the present invention. Variations or substitutions that any skilled one who is familiar with this art could readily think of within the disclosed technical scope of the present invention shall fall within the protection scope of the present invention. Accordingly, the protection scope of the present invention should be defined by the protection scope of the claims.

## Claims

1. An array substrate, comprising:
multiple pixel groups arranged in a matrix form,
gate lines arranged transversely which are corresponding to the pixel groups, and
first data lines and second data lines arranged longitudinally which are corresponding to the pixel groups,
wherein each pixel group comprises a first pixel unit and a second pixel unit, which are located on two sides of a corresponding gate line and connected to the gate line respectively;
the first data line is connected to the first pixel unit in the corresponding pixel group to provide a data signal to the first pixel unit, and the second data line is connected to the second pixel unit in the corresponding pixel group to provide a data signal to the second pixel unit; and
wherein, the gate lines on the periphery of the pixel units are formed by metal of the same layer.

2. The array substrate of claim 1, wherein the first data line and the second data line corresponding to the pixel group are arranged on two sides of the pixel group respectively.

3. The array substrate of claim 1 or 2, further comprising multiple multistage output units, each of the multistage output units corresponding to one pixel group;
wherein the multistage output unit decomposes signals output by a data line driving circuit into data signals output via the first data line and the second data line respectively.

4. The array substrate of claim 3, wherein the multistage output unit comprises:
a first output module, for converting the signals output by the data line driving circuit into first data signals output by the first data line; and
a second output module, for converting the signals output by the data line driving circuit into second data signals output by the second data line.

5. The array substrate of claim 4, wherein the first output module comprises:
a first transistor, including a source connected with the first data line, a gate connected with a first switch signal and a drain connected with the data line; and
a first capacitor, including one end connected with the first data line and the other end being grounded; and
the second output module comprises:
a second transistor, including a source connected with the second data line, a gate connected with second switch signal and a drain connected with the data line; and
a second capacitor, including one end connected with the second data line and the other end being grounded.

6. A display device, comprising the array substrate of any one of claims 1-5.

7. A method for driving the array substrate of claim 1, comprising the following steps:
inputting a row driving signal to the gate line in a current row, and controlling the first pixel unit and the second pixel unit in the pixel group corresponding to the gate line to be turned on;
inputting a first control signal through a first data line of each pixel group to charge the first pixel unit in the pixel group;
inputting a second control signal through a second data line of each pixel group to charge the second pixel unit in the pixel group;
stop inputting the row driving signal to the gate line in the current row, and inputting the row driving signal to the gate line in the next row.

8. The method of claim 7, wherein the array substrate comprises the first transistor and the second transistor of claim 5, and the method comprises:
in the first half cycle of a display cycle of each pixel group, controlling the first transistor to be turned on through a first switch signal, controlling the second transistor to be turned off through a second switch signal, and outputting the first control signal to the first data line through the first transistor; and
in the second half cycle of the display cycle of each pixel group, controlling the first transistor to be turned off through the first switch signal, controlling the second transistor to be turned on through the second switch signal, and outputting the second control signal to the second data line through the second transistor.
